Europäisches Patentamt

European Patent Office

Office européen des brevets

(11) Veröffentlichungsnummer: 0 193 127

A1

## EUROPÄISCHE PATENTANMELDUNG

(21) Anmeldenummer: 86102264.8

(22) Anmeldetag: 21.02.86

(51) Int. Cl.⁴: H01L 23/48 , H01L 21/60 , H01L 21/48

(30) Priorität: 25.02.85 DE 3506581

(43) Veröffentlichungstag der Anmeldung:
03.09.86 Patentblatt 86/36

(84) Benannte Vertragsstaaten:
AT CH DE FR GB LI NL

(71) Anmelder: Siemens Aktiengesellschaft Berlin und München
Wittelsbacherplatz 2
D-8000 München 2(DE)

(72) Erfinder: Pammer, Erich, Dr. rer. nat.
Platanenstrasse 59
D-8021 Taufkirchen(DE)

(54) Filmmontierter Schaltkreis und Verfahren zu seiner Herstellung.

(57) Ein filmmontierter Schaltkreis (Mikropack) enthält einen Halbleiterchip (1) mit höckerartigen Anschlußkontakten (2) und einen Trägerfilm (3) mit metallischen Leiterbahnen (5). Die Leiterbahnen (5) weisen an ihrem einen Ende Außenanschlußkontakte (7) aus Lotmaterial auf, die einer Verbindung mit einer Außenbeschaltung dienen. An ihrem anderen Ende weisen sie ebenfalls Lotmaterial enthaltende Anschlußflächen (6) auf, die mit den Anschlußkontakten (2) des Halbleiterchips (1) eine durch Löten erzielte Legierung bilden. Beim Herstellverfahren werden die Lotmaterialien galvanisch abgeschieden. Für das Lotmaterial der Anschlußflächen (6) und die Anschlußkontakte (2) des Halbleiterchips (1) werden Materialien vorgeschlagen, die beim Löten eine Legierung ausbilden in einem Legierungsverhältnis, das einem eutektischen Punkt entspricht mit einem Schmelzpunkt, der einerseits mindestens 20° C über dem Schmelzpunkt des Lotes der Außenanschlußkontakte (7) liegt und andererseits noch unter einem Wert liegt, bei dem der Halbleiterchip (1) gerade noch nicht beschädigt wird. Als Lotmaterial eignen sich insbesondere Indium und Gallium. Als Material für die Anschlußkontakte (2) eignen sich vorzugsweise Gold, Gold-Kupfer-und Gold-Silber-Legierungen.

# FIG 2

## Filmmontierter Schaltkreis und Verfahren zu seiner Herstellung

Die Erfindung betrifft einen filmmontierten Schaltkreis - (Mikropack) und ein Verfahren zu seiner Herstellung nach den Oberbegriffen der Patentansprüche 1 und 14.

Filmmontierte Schaltkreise, auch Mikropacks genannt, sind in der Halbleiterindustrie mittlerweile ebenso bekannt wie Schaltkreise mit herkömmlichen Gehäusen (Keramik-, Plastikgehäuse).

In der deutschen Offenlegungsschrift ist der grundsätzliche Aufbau eines Mikropacks kurz beschrieben. Er beinhaltet im wesentlichen einen Trägerfilm und einen Halbleiterchip. Elektrische Verbindungen zwischen dem Trägerfilm und dem Halbleiterchip können dabei z.B. durch Löten hergestellt werden. Meist enthält der Trägerfilm überwiegend Kunststoff, oft Kapton. Darüberhinaus weist er im allgemeinen noch metallische Leiterbahnen nach Art einer Spinne auf, deren eine Enden (Anschlußflächen) mit dem Halbleiterchip zu verbinden sind (bekannte Verfahren sind Thermokompression und Löten) und deren andere Enden als Außenanschlußkontakte zur weiteren Verwendung dienen. Beispielsweise können Mikropacks auf Leiterplatten eingesetzt werden. Notwendige elektrische Verbindungen, die gleichzeitig einer mechanischen Stabilisierung dienen, werden dabei durch gelötete Drahtverbindungen zwischen Leiterbahnen oder Lötstützpunkten der Leiterplatten und den Außenanschlußkontakten der Mikropacks hergestellt.

Beide Lötvorgänge, nämlich Herstellen der Verbindungen zwischen den Leiterbahnen der Leiterplatten und den Außenanschlußkontakten der Mikropacks sowie Verlöten des Halbleiterchips mit den spinnenartigen, metallischen Leiterbahnen des Trägerfilms finden bekanntlich räumlich eng benachbart statt. Dabei besteht die große Gefahr, daß während des Lötens an den Außenanschlußkontakten des Mikropacks die dabei angelegte Wärmemenge z. B mittels eines Wärmetransportes über die metallischen, spinnenartigen Leiterbahnen oder eine durch einen verwendeten Lötstempel verursachte Wärmestrahlung die Lötstellen zwischen den als Anschlußflächen ausgebildeten Enden der Leiterbahnen und höckerartigen Anschlußkontakten der Halbleiterchips so stark erwärmt, daß das Lot dort schmilzt und die Lötstelle unterbrochen wird. Diese Gefahr wird noch vergrössert durch die Möglichkeit, daß solche Lötvorgänge nicht durch den Hersteller eines Mikropacks durchgeführt werden, sondern erst beim Kunden, der unter Umständen weniger geübt im Umgang mit Mikropacks ist als der Hersteller.

Die Möglichkeit, Mikropacks erst durch den Kunden in eine zu verwendende Außenbeschaltung (z.B. auf einer Leiterplatte) einlöten zu lassen, wurde von den Herstellern der Mikropacks bisher durchwegs ablehnend beurteilt. Diese Möglichkeit bedingt nämlich außer der oben genannten Gefahr auch noch eine zusätzliche Lagerhaltung von Mikropacks beim Kunden über einen längeren Zeitraum hinweg.

Das zur Herstellung guter Lötfähigkeit auf die Außenanschlußkontakte der Mikropacks bisher stromlos abgeschiedene Zinn als Lotmaterial verhindert jedoch durch bald einsetzende Oxid-und Korrosionsbildung den Erhalt guter Lötfähigkeit für den benötigten längeren Zeitraum. Bereits nach weniger als drei Wochen ist dadurch die Lötfähigkeit nicht mehr ausreichend. Als Zielvorstellung für den Erhalt guter Lötfähigkeit dient dabei ein Zeitraum von mindestens einem Jahr.

Des weiteren wird bisher üblicherweise Zinn als Lotmaterial stromlos abgeschieden. Dies läßt sich zwar recht preisgünstig durchführen, führt jedoch zu elektrisch unzuverlässigem Verhalten des Schaltkreises in Form von Überschlägen, Kurzschlüssen und Ähnlichem. Die Ursache liegt in der Bildung von haarfeinen Einkristallnadeln aus Zinn beim stromlosen Abscheiden ("Whiskerbildung").

Aufgabe der vorliegenden Erfindung ist es deshalb, einen filmmontierten Schaltkreis (Mikropack) vorzuschlagen, der einerseits Löten an den Außenanschlußkontakten von Trägerfilmen von Mikropacks zuläßt, ohne dabei die Lötverbindungen zwischen den spinnenartigen, metallischen Leiterbahnen und den Anschlußkontakten der Halbleiterchips zu beeinträchtigen, und der es andererseits dem Hersteller auch ermöglicht, die Lötbarkeit an den Außenanschlußkontakten für einen wesentlich längeren Zeitraum als bisher üblich zu erhalten. Außerdem soll die elektrische Zuverlässigkeit von Mikropacks dadurch erhöht werden, daß die Bildung der genannten haarfeinen Einkristallnadeln verhindert wird. Des weiteren soll ein Verfahren angegeben werden, das die Herstellung dieses vorteilhaften filmmontierten Schaltkreises ermöglicht.

Diese Aufgabe wird bei einem Schaltkreis der eingangs genannten Art durch die kennzeichnenden Merkmale des Patentanspruches 1 sowie bei einem entsprechenden Verfahren zu seiner Herstellung durch die kennzeichnenden Merkmale des Patentanspruches 14 gelöst.

Die Erfindung ist anwendbar auf alle bekannten Trägerfilme mit metallischen Leiterbahnen aus lötbarem Material. Sie ist außerdem unabhängig von der Halbleitertechnologie, die beim verwendeten Halbleiterchip angewandt wird. Einzige Bedingung ist, daß das zumindest in einem Bereich der höckerartigen Anschlußkontakte, in dem der Lötvorgang erfolgt, verwendete Material lötfähig ist und daß dieses Material zusammen mit dem verwendeten Lot eine Legierung bildet, deren Schmelzpunkttemperaturkurve in Abhängigkeit vom Legierungsverhältnis (mindestens) einen eutektischen Punkt aufweist, der einerseits deutlich (z.B. 20° C) über dem Schmelzpunkt der bekannten Lote, die beim Verlöten der Außenanschlußkontakte eingesetzt werden, liegt, und der andererseits noch nicht so hoch ist, daß beim Lötvorgang der Halbleiterchip thermisch zerstört wird.

Eine ideale Kombination Material eines höckerartigen Anschlußkontaktes -verwendetes Lotmaterial stellen dabei die Metalle Gold und Zinn dar. Zinn hat einen Schmelzpunkt bei ungefähr 230° C; ein geeigneter eutektischer Punkt der entsprechenden Legierung mit Gold liegt bei 29,3 Atom-% Zinn mit einem Schmelzpunkt von ca. 280° C (s. Hansen, Constitution of Binary Alloys, 1958, Fig. 135, Seite 233). Eine weitere Kombinationsmöglichkeit stellt die Verwendung eines Blei-Zinn-Lotes mit geringem Bleigehalt (ca. 10 Atom-% Blei) als Lotmaterial und von Gold als Material für die metallischen Anschlußkontakte des Halbleiterchips dar. Anstelle von reinem Gold können auch Gold-Kupfer- und Gold-Silber-Legierungen verwendet werden.

Vorteilhafte Ausgestaltungen und Weiterbildungen sind in Unteransprüchen gekennzeichnet.

Im folgenden wird die Erfindung anhand der Fig. 1 bis 13 beschrieben.

Es zeigen, jeweils unmaßstäblich gezeichnet,

Fig. 1: ein erfindungsgemäßes Mikropack in Draufsicht,

Fig. 2: ein erfindungsgemäßes Mikropack im Querschnitt,

Fig. 3: eine vergrößerte Einzelheit aus Fig. 2 vor dem Verlöten,

Fig. 4: eine vergrößerte Einzelheit aus Fig. 2 nach dem Verlöten,

Fig. 5: eine gegenüber Fig. 1 vergrößerte Leiterbahn mit daraufliegender Anschlußfläche und Außenanschlußkontakt,

Fig. 6 bis 12: verschiedene Stadien des erfindungsgemäßen Herstellungsverfahrens,

Fig. 13: Versatz einer Anschlußfläche gegenüber einer Leiterbahn, verursacht durch Dejustieren von Fotolackschichten.

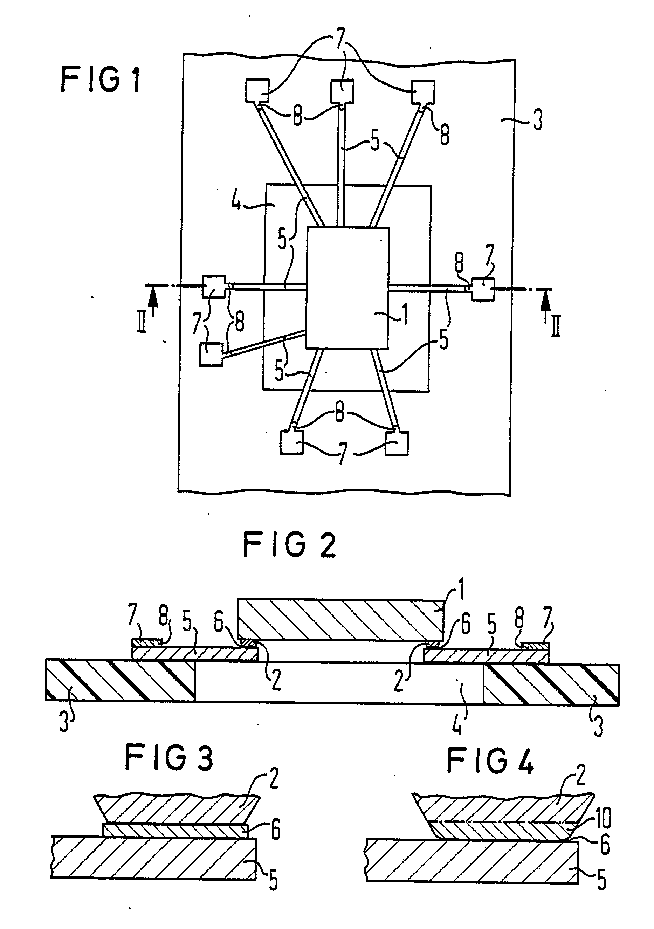

In Fig. 1 ist ein erfindungsgemäßes Mikropack in Draufsicht dargestellt. Zur Verdeutlichung insbesondere der erfindungswesentlichen Merkmale wurde längs der Linie II-II ein in Fig. 2 dargestellter Querschnitt durchgeführt. Ein Halbleiterchip 1 ist, in Draufsicht betrachtet, innerhalb eines fensterartigen Ausschnittes 4 aus einem Trägerfilm 3 angeordnet. Der Trägerfilm 3 enthält überwiegend Kunststoff, vorzugsweise Kapton. Er kann jedoch überwiegend auch andere Stoffe enthalten, wie sonstige thermisch beständige Kunststoffe oder keramisches Material. Auf dem Trägerfilm 3 sind Leiterbahnen 5 angeordnet, die bis in den fensterartigen Ausschnitt 4 hineinreichen. Sie weisen an ihrem einen Ende innerhalb des fensterartigen Ausschnittes 4 Anschlußflächen 6 auf, die der elektrischen Verbindung mit höckerartigen metallischen Anschlußkontakten 2 des Halbleiterchips 1 dienen. Gleichzeitig wirken diese Leiterbahnen 5 mit ihren elektrischen Verbindungen auch als mechanische Fixierung des Halbleiterchips 1 bezüglich des Trägerfilmes 3. Die Leiterbahnen 5 enthalten überwiegend bis ausschließlich lötbares Material wie z.B. Kupfer. Solche Leiterbahnen sind üblicherweise ca. 35 $\mu$m dick. Die Anschlußkontakte 2 des Halbleiterchips 1 enthalten eine Metallegierung, die durch Verlöten der Anschlußkontakte 2 mit Lotmaterial der Anschlußflächen 6 entsteht.

In einer vorteilhaften Weiterbildung der Erfindung ist die Metallegierung nur in einem, bezogen auf das Volumen der Anschlußkontakte 2, kleinen Bereich 10 ausgebildet (vgl. Fig. 4). Es ist günstig, daß der kleine Bereich 10 1/4 bis 1/20 des Volumens der Anschlußkontakte 2 beträgt.

Ausgangsmaterial der Metallegierung sind, wie in Fig. 3 gezeigt, auf Seiten der Anschlußflächen 6 ein Lotmaterial und auf Seiten der Anschlußkontakte 2 ein Metall, welche beim Verlöten eine Legierung bilden können in einem Legierungsverhältnis, das einem eutektische Punkt entspricht, bei dem die Schmelzpunkttemperatur der Legierung einerseits mindestens 20° C über der eines reinen Lotmaterials von Außenanschlußkontakten 7 liegt und andererseits noch unter einem Wert liegt, bei dem beim Löten der Halbleiterchip 1 thermisch gerade noch nicht beschädigt wird. Ein genauer Wert für die Obergrenze hängt sowohl von der Lötdauer und dem beim Verlöten ausgeübten Kontaktdruck als auch vom verwendeten Halbleitermaterial des Halbleiterchips 1 ab. Er beträgt bei einer Lötdauer von 1 sec. und einem Kontaktdruck von 20 cN bei Silizium ca. 550° C.

Als Kombination Lotmaterial -Metall der Anschlußkontakte 2 bieten sich Zinn und Gold an. Eine Gold-Zinn-Legierung besitzt bei 29,3 Atom-% Zinnanteil einen eutektischen Punkt mit ungefähr 280° C Schmelztemperatur, der die oben genannte Bedingung erfüllt. Anstelle von reinem Zinn kann das Lotmaterial auch eine Blei-Zinn-Legierung mit geringem Bleigehalt (ca. 10 Atom-% Blei) enthalten. Anstelle von Gold können die Anschlußkontakte 2 auch eine Gold-Kupfer-Legierung oder eine Gold-Silber-Legierung enthalten. Die Anschlußkontakte 2 brauchen vor dem Verlöten nicht vollständig aus dem ausgewählten Metall zu bestehen, sie können auch eine metallische Schichtfolge mit dem ausgewählten Metall in einem Oberflächenbereich an der Seite eines Anschlußkontaktes 2 enthalten, an der die Verlötung erfolgt. Der Aufbau von Anschlußkontakten 2 aus metallischen Schichtfolgen allgemein ist bekannt.

Die Verwendung von galvanisch abgeschiedenem Lotmaterial anstelle von stromlos abgeschiedenem Lot hat unter anderem folgende wichtige Vorteile:

a) Oberflächen von galvanisch abgeschiedenem Lot bleiben länger lötbar: mindestens ein Jahr, verglichen mit zwei bis maximal drei Wochen bei stromlos abgeschiedenen Loten,

b) stromlos abgeschiedene Lote bilden bei der Abscheidung seitlich abstehende Einkristallnadeln ("Whisker-Bildung", z.B. 1 bis 2 $\mu$m dick, 5 bis 30 $\mu$m lang), die bei heutzutage üblichen, geringen Abständen zwischen den einzelnen Leiterbahnen 5 bzw. Anschlußflächen 6 leicht zur Bildung von Kurzschlüssen dienen können. Dies tritt bei galvanischer Abscheidung nicht auf.

c) Mit galvanischer Abscheidung lassen sich größere Lotstärken erzielen.

Wie in den Fig. 1, 2 und vor allem 5 gezeigt, befinden sich an dem anderen Ende der Leiterbahnen 5 Außenanschlußkontakte 7 mit üblicherweise demselben Lotmaterial - ebenfalls in vorteilhafter Weise galvanisch abgeschieden -, wobei das Lotmaterial in einem, verglichen mit der Gesamtlänge der Leiterbahn 5, kleinen Bereich 8 auch die Leiterbahn 5 bedecken kann. Unterhalb des Lotmaterials der Außenanschlußkontakte 7 setzt sich das Material der Leiterbahn 5 ganzflächig fort. Bezüglich der Vorteile bei der Verwendung von galvanisch abgeschiedenem Lot für die Außenanschlußkontakte 7 gilt dasselbe wie bei den Anschlußflächen 6.

In einer vorteilhaften Weiterbildung der Erfindung ist es auch möglich, daß das Lotmaterial der Außenanschlußkontakte 7 ein anderes ist als das der Anschlußflächen 6. Vorteilhafterweise beträgt die Dicke der auf die Anschlußflächen 6 und die Außenanschlußkontakte 7 abgeschiedenen Lotmaterialien jeweils 1 bis 15 $\mu$m.

Da der Grundgedanke der Lehre der vorliegenden Erfindung unabhängig von Material und Ausgestaltung des Trägerfilmes 3 ist, liegt auch ein die vorstehend beschriebenen Merkmale aufweisender filmmontierter Schaltkreis im Bereich der Erfindung, der einen Trägerfilm 3 ohne den fensterartigen Ausschnitt 4 aufweist. Dabei sind dann natürlich die Leiterbahnen 5 vollständig auf dem Trägerfilm 3 angeordnet.

Die Kombination der erfindungswesentlichen Merkmale "Verwendung von Lotmaterial und Material der Anschlußkontakte 2", die den oben genannten Temperaturbedingungen bezüglich des eutektischen Punktes sowie "Verwendung galvanisch abgeschiedenen Lotmaterials" ermöglichen dem Hersteller von Mikropacks, sich damit einen neuen Markt zu eröffnen: Es ist nunmehr möglich, Mikropacks ohne an die Außenanschlußkontakte 7 angeschlossene Außenbeschaltungen zu verkaufen. Der Kunde kann dann später den Anschluß mittels Löten in einem Temperaturbereich, der zwischen dem Schmelzpunkt des auf den Außenanschlußkontakten 7 aufgebrachten Lotes und dem der Metallegierung 10 liegt, selbst vornehmen, ohne befürchten zu müssen, daß sich dabei die Lötverbindungen zwischen den Anschlußkontakten 2 des Halbleiterchips 1 und den Anschlußflächen 6 lösen. Des weiteren kann er den Anschluß bis zu einem Jahr nach Herstellung des Mikropacks vornehmen, ohne dann durch schlechte Lötfähigkeit beeinträchtigt zu werden.

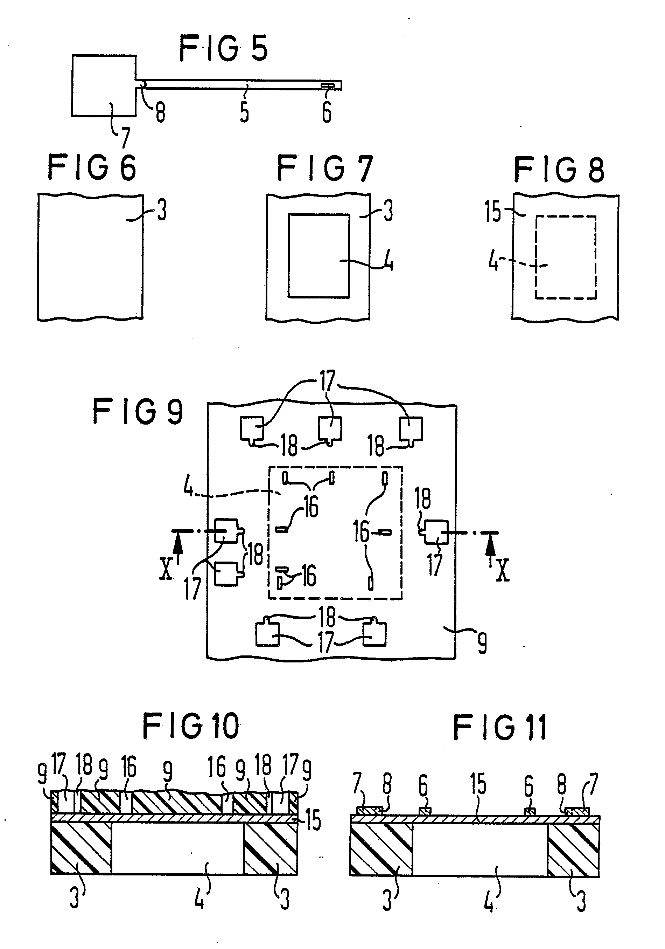

Gemäß den Fig. 6 bis 12 wird der erfindungsgemäße Schaltkreis wie nachstehend beschrieben hergestellt: In einen Trägerfilm 3 aus einem der bereits genannten Materialien wird ein fensterartiger Ausschnitt 4, beispielsweise durch Schneiden oder Stanzen, eingebracht. Daraufhin wird eine Hauptfläche des Trägerfilms 3 ganzflächig, d.h. einschließlich des fensterartigen Ausschnittes 4 mit einer Metallfolie 15 aus lötbarem Material überzogen. Dazu kann beispielsweise eine Kupferfolie in einer Stärke von ca. 35 $\mu$m verwendet werden. Dem Fachmann ist dies als Stand der Technik geläufig. Fig. 8 zeigt das künftige Mikropack nach diesem Verfahrensschritt; der von der Metallfolie 15 verdeckte fensterartige Ausschnitt 4 ist mit gestrichelten Linien dargestellt.

Das Einbringen des fensterartigen Ausschnittes 4 ist bei filmmontierten Schaltkreisen zwar üblich, kann jedoch durchaus entfallen.

Auf die Metallfolie 15 wird nun ganzflächig eine erste Fotolackschicht 9 (Fig. 9, 10) aufgetragen und mit üblichen Mitteln so strukturiert, daß Stellen 16, 17, 18 wieder frei von der Fotolackschicht 9 sind, an denen sich beim fertigen Mikropack die, jeweils Lotmaterial enthaltenden, Anschlußflächen 6, die Außenanschlußkontakte 7 sowie gegebenenfalls ein räumlich an die Außenanschlußkontakte 7 sich anschließender, verglichen mit der Länge der Leiterbahnen 5, sehr kurzer Bereich 8 auf den Leiterbahnen 5 befinden. Auf die Metallfolie 15 wird nun an den von der ersten Fotolackschicht 9 freigelegten Stellen 16, 17, 18 Lotmaterial galvanisch abgeschieden. In vorteilhafter Weiterbildung der Erfindung kann dabei auf die Stellen 16 und 18 ein anderes Lotmaterial abgeschieden werden wie auf die Stellen 17. Das Lotmaterial wird vorteilhafterweise jeweils in einer Dicke von 1 bis 15 $\mu$m abgeschieden. Als Lotmaterial wird dabei insbesondere für die künftigen Anschlußflächen 6 ein Metall verwendet, das in Verbindung mit dem Metall der Anschlußkontakte 2 eine Legierung bilden kann, mit einem Legierungsverhältnis, das einem eutektischen Punkt entspricht, bei dem die zugehörige Schmelztemperatur einerseits mindestens 20° C über der des für die künftigen Außenanschlußkontakte 7 verwendeten Lotmaterials liegt, und andererseits noch unter einem Wert liegt, bei dem beim Verlöten des Lotmaterials mit den Anschlußkontakten 2 des Halbleiterchip 1 noch nicht thermisch beschädigt wird. Ein genauer Wert für die Obergrenze hängt sowohl von der Lötdauer und dem beim Verlöten ausgeübten Kontaktdruck als auch vom verwendeten Halbleitermaterial des Halbleiterchips 1 ab. Er beträgt bei einer Lötdauer von 1 sec. und einem Kontaktdruck von 20 cN bei Silizium ca. 550° C. Als Lotmaterial sind Zinn oder eine Blei-Zinn-Legierung mit niedrigem Bleigehalt (ca. 10 Atom-% Blei) geeignet. Als Material für die Anschlußkontakte 2 werden bei der Herstellung des Halbleiterchips 1, mindestens in einem Oberflächenbereich einer Seite, an der die Lötung erfolgen soll, vorzugsweise Gold oder Gold-Kupfer- bzw. Gold-Silber-Legierungen verwendet.

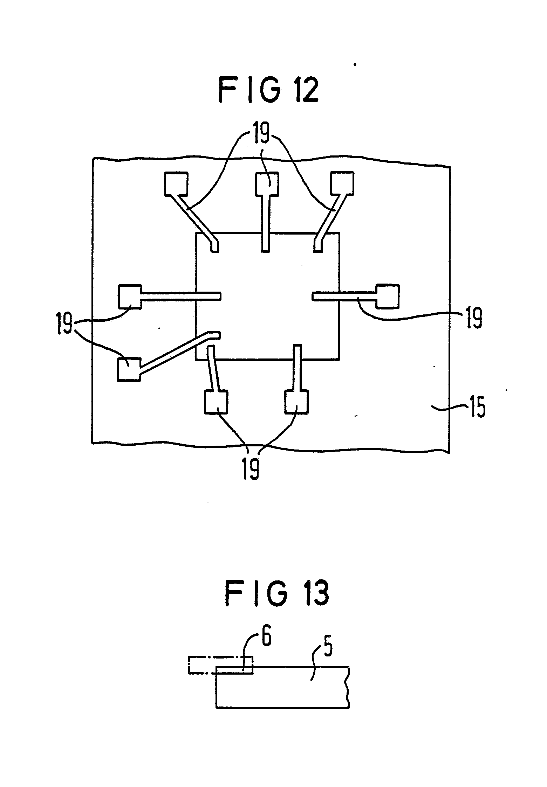

An das galvanische Abscheiden des Lotmaterials schließt sich ein Entfernen der restlichen ersten Fotolackschicht 9 mit üblichen Mitteln an. Das Ergebnis dieses Verarbeitungsschrittes ist in Fig. 11 dargestellt. Jetzt wird, wiederum ganzflächig, auf die Metallfolie 15 und das galvanisch abgeschiedene Lotmaterial eine zweite Fotolackschicht aufgebracht und so strukturiert, daß die Stellen, an denen sich die Anschlußflächen 6, die Außenanschlußkontakte 7, gegebenenfalls samt den sehr kurzen Bereichen 8 sowie die Leiterbahnen 5 des fertigen Mikropacks befinden, mit Fotolack 19 bedeckt bleiben, wie in Fig. 12 dargestellt. Daraufhin wird die Metallfolie 15 mit üblichen Mitteln so strukturiert, daß zusätzlich zu den durch das galvanische Abscheiden entstandenen Anschlußflächen 6 und den Außenanschlußkontakten 7, an die sich gegebenenfalls die sehr kurzen Bereiche 8 anschließen, die Leiterbahnen 5 entstehen. Die Strukturierung der zweiten Fotolackschicht ist dabei so vorzunehmen, daß beim nachfolgenden Strukturieren der Metallfolie 15 zumindest an den Anschlußflächen 6 das galvanisch abgeschiedene Lotmaterial nicht mitstrukturiert wird. Dies könnte z.B. durch isotropisches Unterätzen geschehen. In der Praxis bedeutet dies, daß die strukturierte zweite Fotolackschicht 19 mehr als die gewünschte Grundfläche der Anschlußfläche 6 bedeckt ("Überlappung").

Eine einfache Faustregel zur Bemessung dieser Überlappung besagt, daß, bezogen auf eine Randlinie jeder Anschlußfläche 6, der Fotolack 19 dort mindestens ein Überlappungsmaß aufweisen soll, das der Hälfte der addierten Dicken des galvanisch abgeschiedenen Lotmaterials und der Metallfolie 15 betragen soll.

Im Sinne der Erfindung ist es auch zulässig, die zweite Fotolackschicht an den Anschlußflächen 6 so zu strukturieren, daß, in Draufsicht betrachtet (vgl. Fig. 5), die Anschlußfläche 6 vollständig von der Oberfläche der zugehörigen Leiterbahn 5 nach dem Strukturieren der Metallfolie 15 umgeben ist. Grundsätzlich ist jedoch sehr wichtig, daß die Strukturierung der ersten (9) und der zweiten Fotolackschicht geometrisch so exakt aufeinander abgestimmt sind (z.B. durch entsprechend genaues Justieren von verwendeten Fotomasken), daß kein gegenseitiger Versatz auftritt. Bei einem gegenseitigen Versatz würde nämlich beim Strukturieren der Metallfolie 15 an den Anschlußflächen 6 ein Teil des zuvor abgeschiedenen Lotmaterials wieder mit entfernt, so daß eine Bemessung (die nachfolgend noch beschrieben wird) des Lotmaterials der Anschlußflächen 6 bezüglich der Anschlußkontakte 2 nicht mehr stimmen würd. Ein solcher, beispielsweise durch Dejustieren von Fotomasken entstandener Versatz ist in Fig. 13 dargestellt. Der gestrichelt dargestellte Teil der Anschlußfläche 6 wird beim Strukturieren der Metallfolie 15 zur Leiterbahn 5 mitstrukturiert, d.h. die Anschlußfläche 6 wird unzulässigerweise verkleinert. Nach der Strukturierung der Metallfolie 15 wird die restliche zweite Fotolackschicht 19 entfernt.

Jetzt werden die Anschlußkontakte 2 des Halbleiterchips 1 mit den Anschlußflächen 6 verlötet. Dies geschieht üblicherweise bei einem Kontaktdruck von 20 cN und einer typischen Lötdauer von 1 Sekunde.

Nach der Lehre der vorliegenden Erfindung wird dabei angestrebt, durch das Verlöten an der dabei entstehenden Lötverbindung eine Legierung zu erzeugen, deren Legierungsverhältnis dem Legierungsverhältnis entspricht, das eine eutektische Legierung aus den verwendeten Materialien (z.B. Zinn und Gold) besitzt, deren Schmelzpunkt einerseits mindestens 20° C über dem Schmelzpunkt des Lotmaterials der Außenanschlußkontakte 7 liegt und andererseits, wie vorstehend bereits beschrieben, noch unter einem Wert liegt, bei dem beim Löten der Halbleiterchip 1 thermisch gerade noch nicht beschädigt wird. Zum Erzielen dieser eutektischen Legierung sind folgende Bedingungen notwendig:

a) Die zu verwendenden Materialien müssen so ausgesucht werden, daß eine Legierung entstehen kann mit einem Eutektikum im genannten Temperaturbereich,

b) die Löttemperatur muß über dem Schmelzpunkt des Eutektikums liegen,

c) die Mengenanteile der verwendeten Materialien müssen so aufeinander abgestimmt sein, daß sich das Eutektikum bilden kann.

Im Folgenden soll anhand eines Beispiels gezeigt werden, wie die Mengenanteile der zu verwendenden Materialien (hier: Gold und Zinn) bestimmt werden können: Unter der Annahme, daß der Bereich eines Anschlußkontaktes 2, an den eine Anschlußfläche 6 anzulöten ist, eine Abmessung von 120 x 120 x 18 $\mu$m aufweist (d.h. zum Beispiel, daß der gesamte Anschlußkontakt 2 aus Gold besteht), wiegt dieses Gold 4 $\mu$g. Um den eutektischen Punkt bei 29,3 Atom-% Zinn (entsprechend 20 Gew.-%) bei der Lötung erreichen zu können, muß das Zinn auf 1 $\mu$g bemessen werden. Bei einer angenommenen Dicke des Zinns von 3 $\mu$m entspricht dies einer zu verzinnenden Anschlußfläche 6 von 200 x 200 $\mu$m.

In vorteilhafter Weiterbildung der Erfindung empfiehlt es sich, das Lotmaterial jedoch nicht bezüglich des gesamten lötbaren Materiales eines Anschlußkontaktes 2 zu bemessen, sondern die Bemessung so vorzunehmen, daß sich die Legierung mit dem genannten Legierungsverhältnis beim Löten nur in einem Bereich 10 (s. Fig. 4) ausbildet, der in etwa 1/4 bis 1/20 des Volumens des Anschlußkontaktes 2 beträgt. Dies bietet zum einen für den Halbleiterchip 1 thermische Vorteile und zum Anderen wird eine mögliche Materialverwerfung im Halbleiterchip 1 an den Anschlußkontakten 2 beim Löten vermieden. Des weiteren wird dabei vermieden, daß beim Löten die Anschlußkontkate 2 insgesamt aufschmelzen, wodurch sich aufgrund des verwendeten Kontaktdruckes (z.B. 20 cN) ein zwischen dem Halbleiterchip 1 und den Leiterbahnen 5 sich befindlicher Abstand verringern könnte. Dies könnte nämlich zu unerwünschten elektrischen Kurzschlüssen zwischen dem Halbleiterchip 1 und den Leiterbahnen 5 führen.

**Ansprüche**

1. Filmmontierter Schaltkreis mit einem Trägerfilm (3), auf dem metallische Leiterbahnen (5) aus lötbarem Material derart vorgesehen sind, daß auf den einen Enden der Leiterbahnen (5) Anschlußflächen (6) vorgesehen sind und daß auf den anderen Enden der Leiterbahnen (5) durch Lotmaterial gebildete, einer Lötverbindung mit einer Außenbeschaltung dienenden Außenanschlußkontakte (7) vorgesehen sind, und mit einem metallische, höckerartige Anschlußkontakte (2) aufweisenden Halbleiterchip (1), bei dem die Anschlußkontakte (2) mit den Anschlußflächen (6) verlötet sind und dazu mindestens in einem Oberflächenbereich an ihrer mit den Anschlußflächen (6) in Lötverbindung stehenden Seite aus lötbarem Material ausgebildet sind, **gekennzeichnet durch** folgende Merkmale:

a) die Anschlußflächen (6) enthalten galvanisch abgeschiedenes Lotmaterial,

b) das lötbare Material des Oberflächenbereiches der Anschlußkontakte (2), in dem die Anschlußflächen (6) angelötet sind, bildet zusammen mit dem galvanisch abgeschiedenen Lotmaterial durch das Verlöten eine Legierung in einem Legierungsverhältnis, das durch einen eutektischen Punkt definiert ist, dessen Schmelzpunkttemperatur mindestens 20° C über der Schmelzpunkttemperatur des Lotmaterials der Außenanschlußkontakte (7) liegt, jedoch unterhalb einer Temperatur liegt, ab der der Halbleiterchip (1) beim Verlöten thermisch beschädigt wird,

c) die Außenanschlußkontakte (7) enthalten als Lotmaterial ebenfalls galvanisch abgeschiedenes Lotmaterial.

2. Filmmontierter Schaltkreis nach Anspruch 1, **dadurch gekennzeichnet,** daß der Trägerfilm (3) überwiegend Kunststoff enthält, insbesondere Kapton.

3. Filmmontierter Schaltkreis nach Anspruch 1 oder 2, **dadurch gekennzeichnet,** daß die metallischen Leiterbahnen (5) unmittelbar neben den Außenanschlußkontakten (7) in einem Bereich (8), der klein ist gegenüber der Länge der Leiterbahnen (5), ebenfalls galvanisch abgeschiedenes Lotmaterial enthalten.

4. Filmmontierter Schaltkreis nach Anspruch 1, 2 oder 3, **dadurch gekennzeichnet,** daß als galvanisch abgeschiedenes Lotmaterial Zinn Verwendung findet.

5. Filmmontierter Schaltkreis nach Anspruch 1, 2 oder 3, **dadurch gekennzeichnet,** daß als galvanisch abgeschiedenes Lotmaterial eine Blei-Zinn-Legierung mit einem Bleianteil von bis zu 10 Atom-% Verwendung findet.

6. Filmmontierter Schaltkreis nach einem der Ansprüche 1 bis 5, **dadurch gekennzeichnet,** daß das lötbare Material der Anschlußkontakte (2) im wesentlichen Gold ist.

7. Filmmontierter Schaltkreis nach einem der Ansprüche 1 bis 5, **dadurch gekennzeichnet,** daß das lötbare Material der Anschlußkontakte (2) im wesentlichen eine Gold-Kupfer- oder eine Gold-Silber-Legierung ist.

8. Filmmontierter Schaltkreis nach einem der vorhergehenden Ansprüche, **dadurch gekennzeichnet,** daß das Lotmaterial der Anschlußflächen (6) ein anderes ist als das der Außenanschlußkontakte (7).

9. Filmmontierter Schaltkreis nach einem der vorhergehenden Ansprüche, **dadurch gekennzeichnet,** daß die Dicke des Lotmaterials der Außenanschlußkontakte (7) 1 bis 15 $\mu$m beträgt.

10. Filmmontierter Schaltkreis nach einem der vorhergehenden Ansprüche, **dadurch gekennzeichnet,** daß die Dicke des Lotmaterials der Anschlußflächen (6) vor dem Verlöten 1 bis 15 $\mu$m beträgt.

11. Filmmontierter Schaltkreis nach einem der vorhergehenden Ansprüche, **dadurch gekennzeichnet,** daß die Menge des Lotmaterials der Anschlußflächen (6) bei Verwendung von Zinn als Lotmaterial und Gold als Material der Anschlußkontakte (2) so bemessen ist, daß das Legierungsverhältnis der durch das Verlöten gebildeten Legierung 29,3 Atom-% Zinn beträgt, was dem genannten eutektischen Punkt entspricht.

12. Filmmontierter Schaltkreis nach einem der vorhergehenden Ansprüche, **dadurch gekennzeichnet,** daß die Legierung, die durch das Verlöten der Anschlußkontakte (2) des

Halbleiterchips (1) mit dem Lotmaterial der Anschlußflächen (6) entstanden ist, nur in einem, bezogen auf das Volumen der Anschlußkontakte (2) kleinen Bereich (10) ausgebildet ist (Fig. 4).

13. Filmmontierter Schaltkreis nach Anspruch 12, **dadurch gekennzeichnet,** daß der kleine Bereich (10) 1/4 bis 1/20 des Volumens der Anschlußkontakte (2) des Halbleiterchips (1) beträgt.

14. Verfahren zum Herstellen eines filmmontierten Schaltkreises (Mikropack) gemäß Anspruch 1, bei dem der Trägerfilm (3) auf einer seiner Hauptflächen ganzflächig mit einer Metallfolie (15) aus lötbarem Material überzogen wird, **gekennzeichnet** durch die Anwendung nachstehender Verfahrensschritte:

a) ganzflächiges Aufbringen einer ersten Fotolackschicht - (9) auf die Metallfolie (15), b) Strukturieren der ersten Fotolackschicht (9), sodaß die Stellen (16, 17, 18), an denen die Anschlußflächen (6), die Außenanschlußkontakte (7) und gegebenenfalls die Leiterbahnen (5) des fertigen Mikropacks Lotmaterial enthalten sollen, frei von Fotolack (9) sind,

c) galvanisches Abscheiden von Lotmaterial auf die Stellen (16, 17, 18), die frei von Fotolack (9) sind, sodaß die Anschlußflächen (6) und die Außenanschlußkontakte (7) entstehen,

d) Entfernen der verbliebenen ersten Fotolackschicht (9),

e) ganzflächiges Aufbringen einer zweiten Fotolackschicht,

f) Strukturieren der zweiten Fotolackschicht, sodaß die Anschlußflächen (6) und die Außenanschlußkontakte (7) sowie die Stellen, an denen sich die Leiterbahnen (5) des fertigen Mikropacks befinden sollen, mit Fotolack (19) bedeckt bleiben,

g) Strukturieren der Leiterbahnen (5) durch Abätzen der Metallfolie (15) an den von der zweiten Fotolackschicht freien Flächen,

h) Entfernen der verbliebenen zweiten Fotolackschicht (19),

i) Verlöten der höckerartigen Anschlußkontakte (2) des Halbleiterchips (1) mit den Anschlußflächen (6) des Trägerfilms (3) bei einer Temperatur, die mindestens 20° C über der Schmelzpunkttemperatur des galvanisch abgeschiedenen Lotmaterials liegt, jedoch noch unter einem Wert liegt, bei dem der Halbleiterchip (1) gerade noch nicht beschädigt wird, sodaß sich mindestens in einem Bereich (10), in dem die Lötverbindung entsteht, eine Legierung mit einem Legierungsverhältnis bildet, das dem Legierungsverhältnis beim genannten eutektischen Punkt entspricht.

15. Verfahren nach Anspruch 14, **dadurch gekennzeichnet,** daß als lötbares Material der Anschlußkontakte (2) und als galvanisch abzuscheidendes Lotmaterial Materialien ausgewählt werden, deren Legierung in Abhängigkeit vom Legierungsverhältnis mindestens einen eutektischen Punkt aufweist, bei dem die Schmelztemperatur einerseits mindestens 20° C über der Schmelztemperatur des Lotmaterials der Außenanschlußkontakte (7) liegt und andererseits noch unter einem Wert liegt, bei dem der Halbleiterchip (1) gerade noch nicht beschädigt wird.

16. Verfahren nach Anspruch 14 oder 15, **dadurch gekennzeichnet,** daß als Lotmaterial Zinn galvanisch abgeschieden wird.

17. Verfahren nach Anspruch 14 oder 15, **dadurch gekennzeichnet,** daß als Lotmaterial eine Blei-Zinn-Legierung mit einem Bleianteil von bis zu 10 Atom-% galvanisch abgeschieden wird.

18. Verfahren nach einem der Ansprüche 14 bis 17, **dadurch gekennzeichnet,** daß als Material für den Trägerfilm (3) überwiegend Kunststoff, insbesondere Kapton, verwendet wird.

19. Verfahren nach einem der Ansprüche 14 bis 18, **dadurch gekennzeichnet,** daß die metallischen Anschlußkontakte (2) so ausgestaltet werden, daß sie mindestens in dem Oberflächenbereich der Seite, an der das Verlöten mit den Anschlußflächen (6) erfolgt, im wesentlichen Gold enthalten.

20. Verfahren nach einem der Ansprüche 14 bis 18, **dadurch gekennzeichnet,** daß die metallischen Anschlußkontakte (2) so ausgestaltet werden, daß sie mindestens in dem Oberflächenbereich der Seite, an der das Verlöten mit den Anschlußflächen (6) erfolgt, im wesentlichen eine Gold-Kupfer-oder eine Gold-Silber-Legierung enthalten.

21. Verfahren nach einem der Ansprüche 14 bis 20, **dadurch gekennzeichnet,** daß als Lotmaterial für die Außenanschlußkontakte (7) ein anderes Lotmaterial galvanisch abgeschieden wird wie für die Anschlußflächen (6).

22. Verfahren nach einem der Ansprüche 14 bis 21, **dadurch gekennzeichnet,** daß das Lotmaterial in einer Dicke von 1 bis 15 µm abgeschieden wird.

23. Verfahren nach einem der Ansprüche 14 bis 22, **dadurch gekennzeichnet,** daß das Lotmaterial jeweils ganzflächig auf die Anschlußflächen (6) und die Außenanschlußkontakte (7) abgeschieden wird.

24. Verfahren nach einem der Ansprüche 14 bis 23, **dadurch gekennzeichnet,** daß die Menge des Lotmaterials, das auf die Anschlußflächen (6) abgeschieden wird, bei Verwendung von Zinn als Lotmaterial und Gold als Material der Anschlußkontakte (2) so bemessen wird, daß die durch das Verlöten der beiden Materialien entstehende Legierung 29,3 Atom-% Zinn enthält, was dem genannten eutektischen Punkt Phase entspricht.

25. Verfahren nach einem der Ansprüche 14 bis 24, **dadurch gekennzeichnet,** daß die Menge des Lotmaterials, das auf die Anschlußflächen (6) abgeschieden wird, bezüglich der Menge des lötbaren Materials der Anschlußkontakte (2) so bemessen wird, daß sich eine durch das Verlöten der beiden Materialien entstehende Legierung mit einem Legierungsverhältnis, das dem Legierungsverhältnis dieser Materialien bei dem genannten eutektischen Punkt entspricht, nur in einem, bezogen auf das jeweilige Volumen der Anschlußkontakte (2) kleinen Bereich (10) ausbilden kann.

26. Verfahren nach Anspruch 25, **dadurch gekennzeich-**

net, daß der kleine Bereich (10) so bemessen wird, daß er 1/4 bis 1/20 des Volumens der höckerartigen Anschlußkontakte (2) beträgt.

0 193 127

FIG 1

FIG 2

FIG 3

FIG 4

FIG 5

FIG 6

FIG 7

FIG 8

FIG 9

FIG 10

FIG 11

# F I G 12

19

19

19

15

19

# F I G 13

6

5

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl.4) |
|---|---|---|---|
| Y | US-A-3 621 564 (TANAKA et al.) * Spalte 1, Zeilen 45-48; Spalte 2, Zeilen 5-24; Spalte 4, Zeilen 2-57 * | 1 | H 01 L 23/48<br>H 01 L 21/60<br>H 01 L 21/48 |
| A | | 5,6,11,14,15,19 | |
| Y | DE-A-2 414 297 (SIEMENS) * Anspruch 1 * | 1 | |
| A | | 2,4,16,18 | |
| A | US-A-3 680 198 (WOOD) * Figuren; Zusammenfassung; Spalte 2, Zeile 28 - Spalte 3, Zeile 38 * | 1,4,5,14 | |
| A | GB-A-1 159 979 (IBM) * Seite 1, Zeilen 58-70; Seite 4, Zeilen 5-12 * | 1,14 | |
| A | PATENTS ABSTRACTS OF JAPAN, Band 8, Nr. 181 (E-261) [1618], 21. August 1984; & JP - A - 59 74 653 (HITACHI SEISAKUSHO K.K.) 27-04-1984 * Insgesamt * | 1,8,14,21 | |

---   -/-

RECHERCHIERTE SACHGEBIETE (Int. Cl.4)

H 01 L

Der vorliegende Recherchenbericht wurde für alle Patentansprüche erstellt.

| Recherchenort<br>DEN HAAG | Abschlußdatum der Recherche<br>23-05-1986 | Prüfer<br>IRVINE R.J. |
|---|---|---|

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl 4) |
|---|---|---|---|
| A | PATENTS ABSTRACTS OF JAPAN, Band 6, Nr. 151 (E-124) [1029], 11. August 1982, Seite 91 E 124; & JP - A - 57 73 947 (HITACHI SEISAKUSHO K.K.) 08-05-1982 * Zusammenfassung * | 1,8,14 ,21 | |
| A | MACHINE DESIGN, Band 43, Nr. 1, 7. Januar 1971, Seite 28, Cleveland, US; "New reliability for integrated circuits" * Spalte 2, Absatz 2 * | 4,6,16 ,19 | |
| A | IBM TECHNICAL DISCLOSURE BULLETIN, Band 20, Nr. 8, Januar 1978, Seiten 3087-3088, New York, US; R.J. HERDZIK et al.: "Dual solder evaporation process" * Insgesamt * | 8,21 | |
| A | US-A-4 259 436 (TABUCHI et al.) * Figuren 1,2,4,5; Spalte 1, Zeile 45 - Spalte 2, Zeile 21; Spalte 2, Zeile 42 - Spalte 3, Zeile 46 * | 14 | RECHERCHIERTE SACHGEBIETE (Int. Cl.4) |

Der vorliegende Recherchenbericht wurde für alle Patentansprüche erstellt.

| Recherchenort DEN HAAG | Abschlußdatum der Recherche 23-05-1986 | Prüfer IRVINE R.J. |
|---|---|---|